(19) Europäisches Patentamt

European Patent Office

Office européen des brevets

(11) Veröffentlichungsnummer: **0 280 078 B1**

(12) **EUROPÄISCHE PATENTSCHRIFT**

(45) Veröffentlichungstag der Patentschrift: **04.09.91**

(21) Anmeldenummer: **88101515.0**

(22) Anmeldetag: **03.02.88**

(51) Int. Cl.⁵: **H05K 3/26,** B05B 1/00, C23F 1/08

(54) **Einrichtung zur Reinigung oder chemischen Behandlung von Werkstücken.**

(30) Priorität: **25.02.87 DE 8703114 U**

(43) Veröffentlichungstag der Anmeldung:
**31.08.88 Patentblatt 88/35**

(45) Bekanntmachung des Hinweises auf die
Patenterteilung:
**04.09.91 Patentblatt 91/36**

(84) Benannte Vertragsstaaten:
**BE CH DE ES FR GB IT LI LU NL SE**

(56) Entgegenhaltungen:
**DE-A- 3 528 575**
**FR-A- 2 335 268**
**FR-A- 2 449 486**
**GB-A- 2 096 490**

(73) Patentinhaber: **SCHERING AKTIENGESELL-
SCHAFT Berlin und Bergkamen
Müllerstrasse 170/178 Postfach 65 03 11
W-1000 Berlin 65(DE)**

(72) Erfinder: **Kallweit, Manfred
Ragniter Allee 3a
W-1000 Berlin 19(DE)**

# Beschreibung

Die Erfindung betrifft eine Einrichtung zur Reinigung oder chemischen Behandlung von Werkstücken, insbesondere Leiterplatten, mittels Lösungen, die aus Düsen auf die Werkstücke geschwallt werden.

Einrichtungen dieser Art gehören bereits zum Stand der Technik (DE-PS 26 06 984; DE-OS 35 28 575). Die bekannten Einrichtungen verwenden einschlitzige Düsenkammern, was den Nachteil hat, ein im Verhältnis zum Transportanteil nur geringen Nutzanteil für die einzelnen Behandlungsstufen zu besitzen; was einen ungenügenden Behandlungseffekt zur Folge hat.

Aufgabe der Erfindung ist die Schaffung einer Einrichtung, welche einen hohen Nutzanteil für die Behandlungsstufen bei gleichzeitig gesteigertem Stoffaustausch der zu behandelnden Werkstücke besitzt.

Diese Aufgabe wird gelöst durch eine Einrichtung mit den kennzeichnenden Merkmalen des Anspruchs 1.

Die erfindungsgemäße Einrichtung ermöglicht in vorteilhafter Weise eine außerordentlich intensive Reinigung von Werkstücken, insbesondere Leiterplatten, und hat den besonderen Vorteil großer Platzeinsparung, was bei Einsatz in Durchlaufanlagen von technischer Bedeutung ist.

Die erfindungsgemäße Einrichtung eignet sich insbesondere zur Reinigung und chemischen Behandlung der Bohrlöcher von horizontal geführten Leiterplatten, wobei der unmittelbare Nutzanteil für die einzelnen Behandlungsstufen bei Verminderung des Transportwalzenteils vergrößert wird. Außerdem läßt sich die Länge derartiger Anlagen vermindern.

Die gekennzeichnete Einrichtung eignet sich außerdem auch zur Aktivierung und Metallisierung dieser Bohrlöcher unter Verwendung üblicher Aktivierungs- und Metallisierungslösungen.

Von besonderem Vorteil ist es, daß sogar kleinste Bohrlochdurchmesser bis zu 0,15 mm sicher konditioniert, aktiviert und/oder metallisiert werden können.

Weitere Vorteile bestehen darin,
daß die Metallisierung, zum Beispiel die chemische Verkupferung, infolge des Wegfalls anhaftender Wasserstoffbläschen sehr verbessert wird,
daß die meisten Prozeßstufen ohne Beheizung durchgeführt werden können und
daß eine Gestellentmetallisierung entfällt.

Die Düse kann vorteilhafterweise in Form einer Perforationsebene vorliegen, die geschlitzt, gelocht oder symmetrisch beziehungsweise unsymmetrisch durchbrochen ist.

Als flüssige Reinigungsmittel können zum Beispiel Wasser, Säuren, wie Schwefelsäure, oder Basen Verwendung finden. Zur Aktivierung lassen sich hierfür übliche Aktivierungslösungen, zum Beispiel auf Basis von Edelmetalllösungen, wie Palladiumsalzlösungen, einsetzen.

Für die chemische und gegebenenfalls galvanische Metallisierung können ebenfalls hierfür übliche Badlösungen verwendet werden.

Ausführungsbeispiele der Erfindung werden in den folgenden Figuren näher beschrieben.

Es stellt dar:

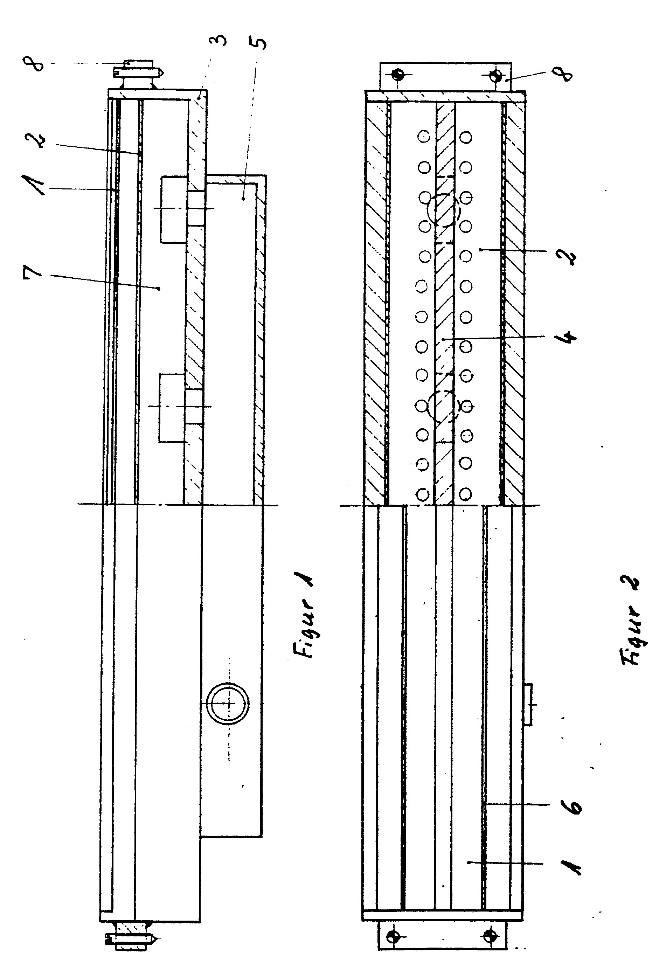

Figur 1 zeigt die Vorderansicht; die linke Hälfte mit den Außenkonturen, die rechte im Schnitt.

Figur 2 zeigt die Draufsicht; die linke Hälfte mit den Außenkonturen, die rechte geschnitten zeigt die beiden Kammern oberhalb des Diffusors.

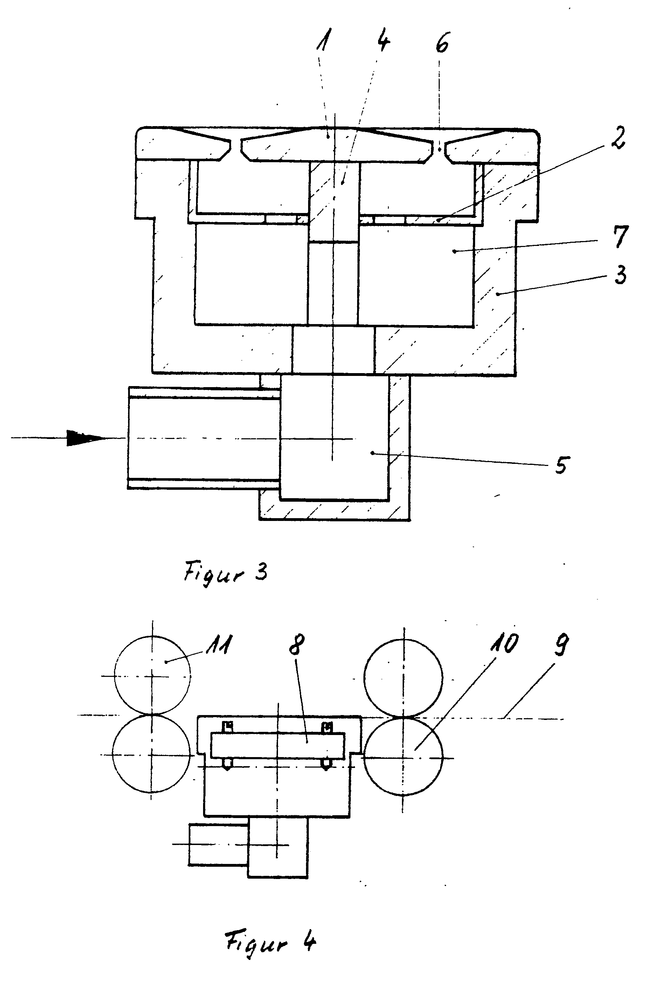

Figur 3 zeigt die Seitenansicht im Schnitt.

Figur 4 zeigt die Seitenansicht mit der an der Stirnfläche befindlichen Justiereinrichtung.

Hierin bedeuten:

| | |
|---|---|
| 1 | obere Schwalldüsenmaske |
| 2 | Perforationsebenen |
| 3 | Gehäusekasten |
| 4 | mittlere Trennwand |
| 5 | unterer Zulaufkasten |
| 6 | Düsenschlitz |
| 7 | Kammer |
| 8 | Justiereinrichtung |
| 9 | Leiter der Durchlaufebene |
| 10 | Transportwalzen |
| 11 | Andrückwalzen |

Die neuerungsgemäße Einrichtung eignet sich insbesondere für die Behandlung von Leiterplatten für gedruckte Schaltungen, die in der Elektronik Verwendung finden.

Die Arbeitsweise der neuerungsgemäßen Einrichtung ist beispielsweise wie folgt:
Die Behandlungsflüssigkeit läuft vom unteren Zulaufkasten (5) durch die im Boden des Gehäusekastens (3) befindlichen Bohrungen ins Innere des Gehäuses. Durch die Anordnung und Ausbildung der mittleren Trennwand (4) und der beiden Perforationsebenen (2) wird erreicht, daß das Medium und die darüber befindlichen Schlitze (6) fließt und sich darüber zwei gleichmäßige, sinusförmige Schwallwellenprofile ausbilden, die die Werkstücke, insbesondere die Leiterplatten -Bohrlöcher optimal durchströmen und durch den Venturi Effekt für einen intensiven Stoffaustausch sorgen.

## Patentansprüche

1. Einrichtung zur Reinigung oder chemischen Behandlung von Werkstücken, insbesondere Leiterplatten, mittels Lösungen, die aus Düsen auf die Werkstücke geschwallt werden, dadurch gekennzeichnet, daß diese aus einem Gehäusekasten (3) mit unterhalb davon angeordneten Zulaufkasten (5) gebildet wird, wobei der Gehäusekasten (3) mittels einer Trennwand (4) in zwei Kammern (7) aufgeteilt ist, in denen sich Perforationsebenen (2) befinden, welche die Kammern gegen die obere Gehäusewand abgrenzen, die aus zwei Düsenschlitzen (6) gebildet wird.

2. Einrichtung gemäß Anspruch 1, dadurch gekennzeichnet, daß die Düsenschlitze (6) spritzwinklig geformt sind.

## Claims

1. Device for the cleaning or chemical treatment of workpieces, in particular printed circuit boards, with the help of solutions sprayed onto the workpieces from nozzles, characterized in that these are formed from a box-type housing (3) with inlet box (5) accommodated underneath, the housing box (3) being divided by a partition (4) into two chambers (7) in which perforated planes (2) are located which separate the chambers from the upper wall of the housing, which is made of two nozzle slots (6).

2. Device in accordance with Claim 1, characterized in that the nozzle slots (6) form an acute angle.

## Revendications

1. Dispositif pour le nettoyage ou le traitement chimique de pièces, en particulier des plaquettes de circuits imprimés, au moyen de solutions projetées sur les pièces par des tuyères, caractérisé en ce que ce dispositif se compose d'un boîtier (3) avec boîtier d'arrivée (5) disposé au-dessous de celui-ci, le boîtier (3) étant séparé en deux chambres (7) par une cloison (4), chambres dans lesquelles se trouvent des plans perforés (2), limitant les chambres par rapport à la paroi supérieure du boîtier, composée de deux fentes de tuyères (6).

2. Dispositif suivant revendication 1, caractérisé en ce que les fentes de tuyères (6) sont acutangulaires.

Figur 1

Figur 2

Figur 3

Figur 4